(19) Europäisches Patentamt
European Patent Office
Office européen des brevets

(11) Publication number: **0 292 189 B1**

(12) **EUROPEAN PATENT SPECIFICATION**

(45) Date of publication of patent specification: **21.07.93**

(51) Int. Cl.⁵: **H03H 17/02**, G06F 7/49, H03H 21/00

(21) Application number: **88304271.5**

(22) Date of filing: **11.05.88**

(54) **Updating cannonic signed digit filter coefficients.**

(30) Priority: **18.05.87 US 52091**

(43) Date of publication of application:
**23.11.88 Bulletin 88/47**

(45) Publication of the grant of the patent:
**21.07.93 Bulletin 93/29**

(84) Designated Contracting States:
**AT BE CH DE ES FR GB GR IT LI LU NL SE**

(56) References cited:

**IEEE TRANSACTIONS ON ACOUSTICS, SPEECH, AND SIGNAL PROCESSING, vol. ASSP-28, no. 5, October 1980, pages 590-592, IEEE, New York, US; R.H. SEEGAL: "The canonical signed digit code structure for FIR filters"**

**ELECTRONIC DESIGN, vol. 35, no. 10, 30th April 1987, pages 68,70,72; D. BURSKY: "Three CMOS DSP chips rev up FIR filtering"**

**IRE TRANSACTIONS ON ELECTRONIC COMPUTERS, vol. EC-10, no. 3, 1961, pages 389-400; A. AVIZIENIS: "Signed-digit numbe representations for fast parallel arithmetic"**

(73) Proprietor: **ADVANCED MICRO DEVICES, INC.**
**901 Thompson Place P.O. Box 3453**
**Sunnyvale, CA 94088(US)**

(72) Inventor: **Vairavan, Kannan P.**
**3300 Parker Lane**
**No.115 Austin Texas 78741(US)**
Inventor: **McLeod, Paul**
**3209 I H 35 South**
**No.2020 Austin Texas 78741(US)**

(74) Representative: **Wright, Hugh Ronald et al**
**Brookes & Martin 52/54 High Holborn**
**London WC1V 6SE (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.6/3.3.1)

## Description

The present invention relates to digital filters and, more particularly, to a method of incrementation and decrementation of Canonic Signed Digit (CSD) filter coefficients.

## BACKGROUND OF THE INVENTION

Digital filters are used in adaptive circuits, such as adaptive subscriber line audio-processing circuits (SLACs), which require periodic updating of the filter coefficients. For example, a SLAC filter should be able to automatically adjust to the subscriber line impedance and the filter coefficients need to be continuously updated to balance the time-varying line impedance.

Updating the coefficients is typically done by the use of counters which increment or decrement their value periodically. The coefficients are typically represented by a sign and shift code. It is therefore required that their coded representation be of a decimal sequence which is a monotone strictly increasing or decreasing.

A paper published in the IEEE Transactions on Acoustics, Speech and Signal Processing Vol. ASSP-28, No. 5, October 1980 at pages 590-592, (New York, USA by R.H. Seegal entitled "The canonical signed digit code structure for FIR filters", discusses a computational structure for FIR filters that combines the advantages of canonical signed digit code (CSC) with the efficiency of the partial sum organisation. The paper discusses how microcode for a microprocessor implementation may be developed directly from the filter coefficients.

## SUMMARY OF THE INVENTION

Coefficient updating algorithms are known to be complex; requiring lengthy mathematical processes. Because it is desired that SLACs, and the like, operate in real time, simplifications of the update algorithms used is necessary. One such simplified algorithm is known as the "sign" algorithm because the coefficient updating ($A_1$ (n)) equation is of the form $A_1$ (n+1) = $A_{1-2}$ (n) + sign (X(n-1))*sign(error(n)), where X(n-1) is the input signal delayed i time units and error (n) is the difference between the ideal filter response and the simplified response.

Accordingly, the present invention provides a method of incrementing and decrementing a decimal-valued digital filter tap coefficient A comprising a plurality of multi-bit coefficients arranged in a most-to-least significant order, each multi-bit coefficient represented in a canonic signed digit (CSD) binary code having a sign portion and a shift code portion, each multi-bit coefficient having a predetermined range and an associated direction indicator, coefficient values within said predetermined range having a predetermined decreasing order whereby said decimal values of A form a monotonically strictly increasing sequence, said incrementation/decrementation method comprising, for each said least-significant to said most-significant multi-bit coefficient, the steps of:

(a) adjusting said sign and shift code portions of said multi-bit coefficient using said direction indicator to take on the next decreased or, increased, value in said decreasing order depending on whether said direction indicator has a first, second, predetermined value, respectively, and

(b) if said adjusted multi-bit coefficient is outside said predetermined range determining a new direction indicator and a new sign portion for said multi-bit coefficient.

Thus it can be seen that each tap coefficient is represented as a number of multi-bit coefficients portions arranged in a most-to-least significant manner. Each multi-bit coefficient portion is represented in a canonic signed digit (CSD) code having a sign portion and a shift code portion. Because the combined CSD-coded values of the individual multi-bit coefficients bears no direct relationship to the decimal value of the coefficient, the method restricts the range of each multi-bit coefficient. By restricting the range of each multi-bit coefficient, the CSD-coded value may be "adjusted" (i.e., incremented, decremented or placed at an endpoint of its range and direction reversed) and the resulting decimal value will be incremented or decremented, accordingly.

The method provides for the sign portion and direction to be readily calculated by an exclusive-OR function of the present signs of the multi-bit coefficients.

## BRIEF DESCRIPTION OF THE DRAWINGS

Fig. 1 is a schematic representation of a digital filter, employing eight tap coefficients.

Fig. 2 is a signal-flow diagram illustrating the derivation of an error signal as the difference between an actual digital filter and an ideal or desired filter.

Fig. 3A is a diagrammatic illustration of the updating method of filter tap coefficients of the instant invention for a 3 nibble CSD format.

Fig. 3B is a diagrammatic illustration of the direction of movement through the filter tap coefficients employed by the method of the instant invention for a 3 nibble CSD format.

Fig. 4 is a unitary drawing comprising Figs. 4A, 4B, 4C and 4D illustrating in flowchart form the update method of the instant invention for a 3 nibble format.

## DETAILED DESCRIPTION OF A PREFERRED EMBODIMENT

Fig. 1 schematically illustrates an 8 tap digital filter, commonly known as a finite impulse response (FIR) filter 10. Such a filter is commonly known as a transversal or non-recursive filter and includes seven storage or delay units 12, eight multipliers 14 and seven adder units 16. As will be appreciated, this circuit will implement a digital filter of the form represented by the filter transfer function equation

$$Y(nT) = A0X0 + A1X\text{-}1 + A2X\text{-}2 + ... + A7X\text{-}7 \qquad (1)$$

where the A0 to A7 represent tap coefficients and the X0 to X-7 represent the present and delayed input values of the input signals X(nT) which are to be multipled by the respective tap coefficients, and Y(nT) is the present output value of the filter.

Other types of digital filter, such as infinite impulse response (IIR) filters are known to those skilled in the art and will not be described herein.

Because of the use of filters in adaptive circuits, such as a subscriber line audio-processing circuit (SLAC) the filter coefficients are not fixed values, but are updated, i.e., incremented or decremented, frequently. For example a SLAC filter should be able to automatically adjust to the subscriber line impedance and the filter coefficients should be continuously updated to balance the time-varying line impedance.

With reference to Fig. 2, if the FIR filter 10 employs a particular updating algorithm, a particular response Y(nT) will be generated for an input X(nT). The difference between Y(nT) generated by filter 10 and that of an ideal filter or a desired filter 18 is determined by a summation node 20 at which the input X-(nT) is applied to actual filter 10 and desired filter 18; their respective outputs applied to a subtractive and additive input, respectively, of node 20. The sum generated by node 20 is an error(nT) signal.

Coefficient updating algorithms are known to be complex; requiring lengthy mathematical processes. Because it is desired that SLACs, and the like, operate in real time, simplifications of the update algorithms used is necessary. One such simplified algorithm is known as the "sign" algorithm because the coefficient updating ($A_i(n)$) equation is of the form $A_i(n+1) = A_{i-1}(n) + \text{sign}(X(n\text{-}1))*\text{sign}(\text{error}(n))$, where X(n-1) is the input signal delayed i time units and error (n) is the difference between the ideal filter response and the simplified response.

As illustrated in Fig. 1 and Equation (1), the filter function is performed by a series of multiplications and accumulations. A multiplication node 14 is implemented by shifting the multiplicand and summing the result with the previous value at a summation node 16. For example, a one-bit multiplication is a shift of M bits, where M is related to the position of the binary ONE in the multiplier (hi) as expressed by the equation:

$$hi = B1*2^{-M}2 + ... + BN*2^{-M}N, \text{ where } Mi \leq Mi+1 \text{ and } Bi = \pm 1.\} \qquad (2)$$

The coefficient updating method of the present invention employs a cannonic signed digit (CSD) binary encoding to represent the filter tap coefficients. The CSD encoding will use n binary coefficients C1, C2, ..., Cn, each called a coefficient "nibble". Each binary coefficient having a shift portion Mi so that the decimal value of a filter tap coefficient A is related to its CSD encoding according to the formula

$$A = [C1*2^{-M1}[1 + C2*2^{-M2}[1 + C3*2^{-M3}[1 + ...[1 + Cn*2^{-Mn}]...] \qquad (3)$$

In general, if n nibbles are employed, the tap coefficient A takes on values from +n to -n. To describe the CSD encoding each coefficient Ci shall be taken to be a four-bit binary number consisting of a sign bit

Si and a three-bit shift code Mi so that Ci = SiMi. Each nibble therefore is representable as a decimal number having a hexadecimal value 0, 1, ..., 8, 9, A, B, C, D, E, F.

As will be explained hereinafter, hexadecimal values 0, 1, 9 and 8 are initially to be excluded from coefficient nibbles. Accordingly, there are $(12)^n$ possible combinations to form a tap coefficient A when using n nibbles. Added to this are "end sequences" employing 0, 1, 9 and 8, as will be explained hereinafter, producing $4^*(12)^{n-1}$ possible end combinations. In addition, there are "tail sequences" employing 0 and 8, producing

$$2*\left[\left\{\frac{\sum_{J=0}^{n-2} 2*J*(12)^J}{J}\right\}+2\right]$$

possible tail combinations.

Accordingly, the total number of useful combinations is given by the formula

$$(12)^n + \left[4*(12)^{n-1}\right] + 2*\left[\left\{\frac{\sum_{J=0}^{n-2} 2*J*(12)^J}{J}\right\}+2\right] \qquad (4)$$

This then is the total number of decimal values possible for a filter tap coefficient A when n nibble coefficients, each being a four-bit (sign + three-bit) binary quantity. For instance, for n = 2, there are 196 possible tap coefficient values; for n = 3, there are 2,356 possible tap coefficient values.

For illustrative purposes only, the coefficient updating method of the present invention will be described in terms of a filter each tap of which has three 4-bit hexadecimal "nibble" coefficients C1, C2 and C3, the most-significant being C1 and the least-significant being C3. Each coefficient nibble consists of a sign bit S and a three-bit shift code M so that

Ci = SiMi i = 1,2,3.

The convention regarding the sign bit, for this description of the method, is that Si = 1 indicates a negative coefficient value and Si = 0 indicates a positive coefficient value; the values are represented in a one's complement notation. This reults in a range of values for each nibble of +1 to -1. In this way, the decimal value of a particular tap coefficient A is given by the formula

$$A = S1 * 2^{-M}1\ (1 + S2 * 2^{-M}2\ (1 + S3 * 2^{-M}3)). \qquad (5)$$

Since each filter tap coefficient has three 4-bit coefficients there are 4,096 possible tap coefficient values in all. The particular values described above will be used in the description of the method but other values could be used and the method of the instant invention would be equally applicable.

Using the Cannonic Signed Digit (CSD) encoding of these 4096 values, many of the tap coefficient values are repeated or do not form part of a sequential pattern suitable for use by counters. By not allowing C2 and C3 to take on the values 0,1,9 or 8, and omitting repeated values, a sequential pattern of 2304 possible CSD encoded values results. The resolution between adjacent values in the resulting 2304 values is very small and eliminating the codes omitted from the 4096 values has a negligible effect on the overall resolution of a tap coefficient A.

However, restricting the CSD encoded values to 2304 values does not allow the resulting tap coefficient A to reach +3 or -3, as would result from a direct application of equation (5). An additional 26 CSD encoded values are placed on each of the values, making a total of 2356 possible CSD coded values. These added codes fit into the pattern of the original 2304 values, by allowing C2 and C3 to take on additional codes outside their normal range, i.e., they take on values 0 and 1.

According to the method of the instant invention then, the values that each hexadecimal coefficient can take are as follows:

```
         most positive                      most negative
         decimal value                      decimal value
    C1:  0  1  2  3  4  5  6  7  F  E  D  C  B  A  9  8
    C2:  0 1   2  3  4  5  6  7  F  E  D  C  B  A
          |
         restricted to end points only, when C1 = 0 or 8
    C3:  0 1   2  3  4  5  6  7  F  E  D  C  B  A
          |
         restricted to end points only, when C1 = 0 or 8
                                    and C2 = 0 or 8.
```

In accordance with these observations, the coefficient update method of the present invention mandates the following conditions on the 4-bit coefficients C1, C2 and C3:

I) C1 may take on all sixteen hex values 0 through 8, shown above.

II) C2 may take on the twelve hex values 2 through A, shown above, except that when C1 = 0 or 8, i.e., M1 = 0 it can take on the values 1 and 0. C2 never takes on the values 9 or 8.

III) C3 may take on the twelve hex values 2 through A, shown above, except that when C1 = 0 or 8 and C2 = 0 or 8, i.e., M1 = 0 and M2 = 0 it can take on the values 1 and 0. C3 never takes on the values 9 or 8.

IV) When C2 changes sign, the C3 sequence changes direction.

V) When C1 changes sign, the C2 and C3 sequences change direction.

If the sign bit S is omitted from the shift code M, the sequence of M values form a loop:

```
M: →2  3  4  5  6  7  7  6  5  4  3  2←
   |_______________loop_______________|
```

This sequence forms the basis of the update method of the present invention. A typical incrementation or decrementation sequence is illustrated in Fig. 3A for 3 nibble CSD format. The diagram shows the movement through the coded tap coefficient values for a particular value of C1 and variable value of C2 and C3 in terms of the shift codes M1, M2 and M3. To restrict the size of the figure, only the representative values of M2 equal to 3, 4 and 5 are shown. However, the pattern shown repeats for all values of M2. The value of M1 is shown in Fig. 2 as "x" which stands for any hexadecimal value that M1 can take on, i.e., "don't care".

Figure 3B diagrammatically illustrates how the sign S1 and S2 of the coefficients C1 and C2 determines the direction of movement through the coded tap values C2 and C3. A ± pattern in Fig. 3 indicates movement in the direction from most positive decimal value to most negative decimal value while a ∓ pattern indicates movement in the direction from most negative to most positive. Selection of the direction of movement is therefore given by the exclusive-OR (exor) function; for example for C3:

| C1 | C2 | C3 |
|---|---|---|
| - | + | + |
| - | - | - |
| + | - | + |
| + | + | - |

The coefficient update method described in terms of three nibble coefficients C1, C2 and C3 can be extended to n nibble coefficients C1, C2, ..., Cn in the following manner: the restrictions imposed on coefficient C3 in condition III, supra, also are imposed on coefficients C4, ..., Cn. Condition IV is generalized to: when Cn-1 changes sign, sequence Cn changes direction and condition V is generalized to: when C1 changes sign, the C2, C3, ..., Cn sequences change direction.

Now with reference to Fig. 4, a unitary drawing illustrating in flowchart form the coefficient update method of the instant invention, the method begins with the current values of the coefficients C1, C2, C3 and the current direction (DIR) of movement through the coded tap values. These values are set at block 100 of Fig. 4A. A variable MASK1 is set to 7 in a block 101 preceding block 100. MASK1 is used in a subroutine COMMON described hereinafter. Block 102 is next entered which calls for splitting the coefficients into their sign and shift code portions and the setting of various flags used later in the method. A FLAG 1 and FLAG2 are initially used to indicate detection of tailend sequence in C3; later FLAG2 and a FLAG 3 are set to ZERO if no coefficient updating is to be performed, set to ONE if coefficient incrementation is to be performed, and set to minus ONE if coefficient decrementation is to be performed.

A block 104 is next entered which begins the method by the updating of C3 and accordingly a S3FLAG is set to ZERO in block 104; S3FLAG indicates reversal of direction of movement through the C3 coefficient values. A decision block 106 is next entered which tests whether S1 exor S2 is a ONE. This block implements the exclusive-OR function described above and determines the proper direction of movement through the C3 coefficient values.

If a direction change is required, the line labelled "Y" ("Y exit") from decision block 106 leads to a block 108 which calls for setting the DIR value to its opposite value. If no direction change is required, the line labelled "N" ("N exit") from decision block 106 leads to a block 110. Block 110 is also entered upon leaving block 108.

Block 108 invokes a subroutine called "COMMON" which is illustrated in flowchart form as Fig. 4D. A description of the COMMON subroutine will be given below in connection with Fig. 4D.

Upon return from COMMON, a decision block 112 is entered which tests whether M3 is less than 2. This test implements condition (III), described above. The N exit from block 112 is taken if M3 is not less than 2 and a block 114 (Fig. 4B) is entered thereupon setting FLAG3 to ZERO indicating that M3 is not less than 2 which completes the update of the C3 portion. The Y-exit from block 112 is taken otherwise which leads to a decision block 116 which tests whether FLAG2 = 0 and S3 = 0. This test determines whether the end of region for M2 has been reached with C3 positive. If so, the Y-exit from block 116 leads to block 118 which sets FLAG3 to ZERO. This action resets FLAG3 if at the end point of an M2 sequence with S3 positive. Block 118 leads to a decision block 120 which tests whether M1 is less than ZERO. If not, the N exit is taken which completes the update of C3 portion; if so, Y-exit is taken and M1 is set to ZERO in a block 122 which then completes the update of C3 portion.

If the N-exit of decision block 116 is taken, then the various combinations of signs S1, S2 and S3 are to be tested; implementing the ex-or function described above. A decision block 124 is first entered which tests whether S1 equals ZERO AND S2 equals ZERO. If so, a Y-exit leads to a decision block 126 which tests whether S3 equals ZERO. If so, a Y-exit leads to block 128 which sets FLAG3 to ONE and then to a block 130 which sets S3 to ONE. If S3 does not equal ZERO, a N-exit of block 126 leads to a block 132 which sets FLAG3 to minus one and then to a block 134 which sets S3 to ZERO.

Upon execution of block 130, 134, or the N-exit of block 124, a decision block 136 is executed which performs analogous tests of S1 equals ZERO and S2 equals ONE. A complete description of this portion of the flowchart, of Fig. 4A, comprising a decision block 138 and blocks 140, 142, 144 and 146, is omitted in the interests of brevity.

With reference now to Fig. 4B, upon execution of block 142, 146, or the N-exit of block 136, a decision block 148 is executed which performs analogous tests if S1 equals ONE and S2 equals ONE. A complete descripton of this portion of the flowchart of Fig. 4B, comprising a decision block 150 and blocks 152, 154, 156 and 158 is omitted in the interest of brevity.

Upon execution of block 154, 158 or the N-exit of block 148, a decision block 160 is executed which performs analogous tests if S1 equals ONE and S2 equals ZERO. A complete description of this portion of the flowchart of Fig. 4B, comprising a decision block 162 and blocks 164, 166, 168 and 170 is likewise omitted.

Upon execution of block 166, 170 or the N-exit of block 160, a block 172 is entered which sets M3 to 2 and then a block 174 is entered which sets S3FLAG to 1. Upon execution of block 114, 174 or 122 the C3 update portion of the method of the preent invention is completed and a block 178 is entered which begins the update of C2. As block 178 is entered, the sign of C3 (S3) has been set and the shift code of C3(M3) has been set to 2.

An S2FLAG indicates reversal of direction of movement through the C2 coefficient values. Block 178 sets S2FLAG to ZERO and thereupon a block 180 is entered which invokes the subroutine "COMMON". Upon return from COMMON a decision block 182 is entered which tests whether M2 is less than 2. The N-exit of block 182 leads to a block 184 which sets FLAG2 to ZERO.

The Y-exit of block 182 leads to a decision block 186 which tests whether FLAG1 equals ZERO AND S2 equals ZERO. This test determines whether the end of region for M1 has been reached with C2 positive. If so, the Y-exit leads to a block 188 which sets FLAG2 to ZERO. The N-exit leads to a block 190 which sets FLAG2 to minus ONE and then on to a decision block 192.

Block 192, a decision block 194 and blocks 196, 198, 200 and 202 perform an analogous ex-or function to that performed by blocks 136, 138, 140, 142, 144 and 146 described herein above and will not be described in further detail. Upon execution of blocks 198, 202 or the N-exit of block 192 a block 204 is entered which sets M2 to 2 and then a block 206 is entered which sets S2FLAG to 1.

Upon execution of block 184, 188 or 206 the C2 update portion of the method of the present invention is completed and a decision block 208 (Fig. 4C) is entered which begins the update of C1. As block 208 is entered, the sign of C2(S2) has been set and the shift code of C2 (M2) has been set to 2.

Now with reference to Fig. 4C, decision block 208 tests whether DX equals ONE and S1 equals ONE. This determines a Y-exit of block 208 leads to a block 210 which sets FLAG2 to its opposite value -FLAG2. Upon execution of block 210 or the N-exit of block 208, a block 212 is executed which invokes the COMMON subroutine.

Upon return from COMMON, a decision block 214 is executed which implements the ex-or functions described hereinabove. These ex-or functions set S2 and S3 by portions of the flowchart of Fig. 4C comprising decision blocks 216, 218, 224, 226 and 228 and blocks 220, 222, 230 and 232. In the interests of brevity their descriptions will be omitted.

Following execution of blocks 230, 232 or the N-exits of decision blocks 214 or 224 the updating of C1 according to the instant invention is completed and a block 234 is entered which begins the reconstruction of C1, C2 and C3 using the updating values determined in the flowchart as are hereinafter described in connection with Fig. 4D.

Block 234 sets S3 to the sign portion of S3, a block 236 is next entered which sets S2 to the sign portion of S2 and a block 238 is next entered which sets S1 to the sign portion of S1. A block 240 is next entered which sets C3 to the sign plus shift code portions of M3. A block 242 is next entered which sets C2 to the sign plus shift code portions of M2 and a block 244 is next entered which sets C1 to the sign plus shift code portions of M1. Finally, a block 246 is entered which calls for reporting the updated values of C1, C2 and C3.

With reference now to Fig. 4D, a flowchart of the COMMON subroutine is shown. Entry to COMMON is by the way of a block 248 which leads to a decision block 250 which tests the S parameter, which will be S3, S2 or S1 depending on whether the subroutine is invoked at block 110, block 180 or block 212, respectively, equals ONE. If so, the Y-exit leads to a block 252 which sets the M parameter, which will be M3, M2 or M1, respectively, to 15-M.

After execution of block 252 or the N-exit to block 250, a block 254 executed which sets the M parameter to M-DIR. The DIR parameter will be DIR, FLAG 3 or FLAG2, respectively, depending on whether the subroutine is invoked at block 110, block 180 or block 212, respectively. This parameter determines whether incrementation, decrementation or no change will be effected in this invokation of COMMON. Next a block 256 is entered which sets the S parameter to the M parameter. Then a block 258 is entered which sets the S parameter to the sign portion of S. A block 260 is next entered which forms the logical AND of the M parameter with the MASK1 value and sets M to the result.

A decision block 262 is entered from block 260 which tests whether the S parameter equals ONE, if so the Y-exit leads to a block 264 which sets M to MASK1-M. Following execution of block 264 or the N exit of block 262 the COMMON routine exists via a block 266 to return to the envoking block 110, 150 or 212 and the parameters S3 and M3, S2 and M2 or S1 and M1 will have been accordingly modified.

The method of the present invention presented as a computer program, written in the "C" programming language, is included as an Appendix.

## Claims

**1.** A method of incrementing and decrementing a decimal-valued digital filter tap coefficient A comprising a plurality of multi-bit coefficients arranged in a most-to-least significant order, each multi-bit coefficient represented in a canonic signed digit (CSD) binary code having a sign portion and a shift code portion, each multi-bit coefficient having a predetermined range and an associated direction indicator, coefficient values within said predetermined range having a predetermined decreasing order whereby said decimal values of A form a monotonically strictly increasing sequence, said incrementation/decrementation method comprising, for each said least-significant to said most-significant multi-bit coefficient, the steps of:

(a) adjusting said sign and shift code portions of said multi-bit coefficient using said direction indicator to take on the next decreased or, increased, value in said decreasing order depending on whether said direction indicator has a first, second, predetermined value, respectively, and
(b) if said adjusted multi-bit coefficient is outside said predetermined range determining a new direction indicator and a new sign portion for said multi-bit coefficient.

**2.** A tap coefficient incrementation/decrementation method according to Claim 1, wherein said tap coefficient A comprises n multi-bit coefficients arranged in said most-to-least significant order C1, C2, C3, ...., Cn, each multi-bit coefficient Ci having said shift code portion Mi wherein said decimal value of A is related to said multi-bit coefficient by the formula

$$A = [C1*2^{-M1} [1+C2*2^{-M2} [1+C3*2^{-M3} [1+ \ldots [1+C_n*2^{-Mn}]\ldots]]]],$$

wherein each said multi-bit coefficient Ci has said predetermined range determined by exclusion of predetermined ones of said binary codes.

**3.** A tap coefficient incrementation/decrementation method according to Claim 2 wherein each said multi-bit coefficient Ci has a hexadecimal binary code, each Ci having a one-bit sign portion Si and having a three-bit shift code portion Mi, wherein each said multi-bit coefficient Ci has said predetermined range comprising said hexadecimal values in which predetermined ones of said hexadecimal values are excluded.

**4.** A tap coefficient incrementation/decrementation method according to Claim 3
wherein said C1 coefficient has said range including all sixteen hexadecimal values arranged in said predetermined decreasing order 0, 1, 2, 3, 4, 5, 6, 7, F, E. D, C, B, A, 9 and 8;
wherein C2 may take on values 0 and 1 only when C1 = 0 or 8.

**5.** A tap coefficient incrementation/decrementation method according to Claim 2 wherein step (b) further calls for when said sign portion of multi-bit coefficient Ci changes: said direction indicator of the multi-bit coefficient Ci + 1 changes, i = 2,...,n-1 and when said sign portion of said direction indicator of said most-significant multi-bit coefficient C1 changes, all said direction indicators of said multi-bit coefficients Ci changes, i = 2,...,n.

## Patentansprüche

**1.** Verfahren zum Inkrementieren und Dekrementieren eines dezimalwertigen digitalen Filterabgriffskoeffizienten A mit mehreren Mehrfachbit-Koeffizienten, die in einer Reihenfolge vom höchst- zum niederwertigsten angeordnet sind, wobei jeder Mehrfachbit-Koeffizient in einem kanonisch mit Vorzeichenziffer (CSD) versehenen Binärcode wiedergegeben ist, der einen vorzeichenteil und einen Schiebecodeteil aufweist, wobei jeder Mehrfachbit-Koeffizient einen vorbestimmten Bereich und einen zugehörigen Richtungsanzeiger hat, wobei Koeffizientenwerte innerhalb des vorbestimmten Bereichs eine vorbestimmte abnehmende Ordnung aufweisen, wodurch die Dezimalwerte von A eine strikt monoton ansteigende Sequenz bilden, wobei das Inkrementier-/Dekrementierverfahren für jeden der Mehrfachbit-Koeffizienten, vom geringstwertigen bis zum höchstwertigen, die folgenden Schritte umfaßt:
(a) Einstellen des Vorzeichen- und Schiebecodeteils des Mehrfachbit-Koeffizienten unter Verwendung des Richtungsanzeigers, um in Abhängigkeit davon, ob der Richtungsanzeiger einen ersten oder zweiten vorbestimmten Wert hat, den nächsten verringerten oder erhöhten Wert in der abnehmenden Ordnung anzunehmen, und
(b) wenn sich der eingestellte Mehrfachbit-Koeffizient außerhalb des vorbestimmten Bereichs befindet, Bestimmen eines neuen Richtungsanzeigers und eines neuen Vorzeichenteils für den Mehrfachbit-Koeffizienten.

**2.** Abgriffskoeffizienteninkrementier-/Dekrementierverfahren nach Anspruch 1, bei dem der Abgriffskoeffizient A n Mehrfachbit-Koeffizienten aufweist, die in der Reihenfolge vom höchst- zum geringstwertigen C1, C2, C3, ....., Cn, angeordnet sind, wobei jeder Mehrfachbit-Koeffizient C1 den Schiebecodeteil Mi aufweist, bei dem der Dezimalwert von A mit dem Mehrfachbit-Koeffizienten durch die Formel

$$A = [C1*2^{-M1} [1+C2*2^{-M2} [1+C3*2^{-M3} [1+ \ldots [1+C_n*2^{-Mn}]\ldots]]]$$

in Beziehung steht, wobei jeder Mehrfachbit-Koeffizient Ci den vorbestimmten Bereich aufweist, der durch Ausschluß vorbestimmter der Binärcodes bestimmt ist.

**3.** Abgriffskoeffizienteninkrementier-/Dekrementierverfahren nach Anspruch 2, bei dem jeder Mehrfachbit-Koeffizient Ci einen Hexadezimal-Binärcode aufweist, jeder Ci einen Ein-Bit-Vorzeichenteil Si und einen Drei-Bit-Schiebcodeteil Mi aufweist, und wobei jeder Mehrfachbit-Koeffizient Ci den die Hexadezimal-Werte umfassenden vorbestimmten Bereich aufweist, in dem vorbestimmte der Hexadezimal-Werte ausgeschlossen sind.

**4.** Abgriffskoeffizienteninkrementier-/Dekrementierverfahren nach Anspruch 3, bei dem der C1-Koeffizient den Bereich aufweist, in dem alle sechzehn Hexadezimal-Werte in der vorbestimmten abnehmenden Ordnung 0, 1, 2, 3, 4, 5, 6, 7, F, E, D, C, B, A, 9 und 8 angeordnet sind;
wobei C2 die Werte 0 und 1 nur annehmen kann, wenn C1 = 0 oder 8 ist.

**5.** Abgrifskoeffizienteninkrementier-/Dekrementierverfahren nach Anspruch 2, bei dem der Schritt (b) ferner erfordert, daß, wenn sich der Vorzeichenteil des Mehrfachbit-Koeffizienten C1 ändert, sich der Richtungsanzeiger des Mehrfachbit-Koeffizienten C1 + 1 mit i = 2, ...,n-1 ändert und daß, wenn sich der Vorzeichenteil des Richtungsanzeigers des höchstwertigen Mehrfachbit-Koeffizienten C1 ändert, sich alle Richtungsanzeiger der Mehrfachbit-Koeffizienten Ci mit i = 2, ..., n ändern.

## Revendications

**1.** Un procédé d'incrémentation et de décrémentation d'un coefficient de prise A de filtre numérique à valeur décimale comprenant une pluralité de coefficients de plusieurs bits classés du plus significatif au moins significatif, chaque coefficient de plusieurs bits représenté en code binaire à chiffre canonique signé (CSD) ayant une partie signe et une partie code de décalage, chaque coefficient de plusieurs bits ayant une plage prédéterminée et un indicateur de direction associé, les valeurs des coefficients au sein de ladite plage prédéterminée ayant un ordre décroissant prédéterminé, par quoi lesdites valeurs décimales de A forment une suite uniformément et strictement croissante, ledit procédé d'incrémentation/décrémentation comportant, pour chacun desdits coefficients de plusieurs bits dudit moins significatif audit plus significatif, les étapes consistant à:

(a) ajuster lesdites parties signe et code de décalage desdits coefficients de plusieurs bits en utilisant ledit indicateur de direction pour adopter la valeur décimale suivante diminuée ou augmentée, dudit ordre décroissant selon que ledit indicateur de direction a, respectivement, une première, ou une seconde, valeur, et

(b) si ledit coefficient de plusieurs bits ajusté est en dehors de ladite plage prédéterminée, déterminer un nouvel indicateur de direction, et une nouvelle partie signe pour ledit coefficient de plusieurs bits.

**2.** Un procédé d'incrémentation/décrémentation de coefficient de prise conforme à la revendication 1, dans lequel ledit coefficient de prise A comprend n coefficients de plusieurs bits classés du plus au moins significatif C1, C2, C3,..., Cn, chaque coefficient de plusieurs bits Ci ayant une dite partie code de décalage Mi dans laquelle ladite valeur décimale de A a une relation avec ledit coefficient de plusieurs bits donnée par la formule:

A = C1*2-M1(1 + C2*2-M2(1 + C3*2-M3(1 + ...(1 + Cn*2-Mn)...)))),

dans lequel ladite plage prédéterminée de chaque dit coefficient de plusieurs bits Ci est déterminée par exclusion de certains prédéterminés desdits codes binaires.

**3.** Un procédé d'incrémentation/décrémentation de coefficient de prise conforme à la revendication 2, dans lequel chaque dit coefficient de plusieurs bits Ci a un code binaire hexadécimal, chaque Ci ayant une partie signe Si de un bit et ayant une partie code de décalage Mi de trois bits, dans lequel chaque dit coefficient de plusieurs bits Ci a une dite plage prédéterminée comprenant lesdites valeurs hexadécimales de laquelle certaines prédéterminées desdites valeurs hexadécimales sont exclues.

**4.** Un procédé d'incrémentation/décrémentation de coefficient de prise conforme à la revendication 3,
dans lequel ladite plage dudit coefficient C1 comporte les seize valeurs hexadécimales classées dans ledit ordre décroissant prédéterminé 0, 1, 2, 3, 4, 5, 6, 7, F, E, D, C, B, A, 9 et 8;
dans lequel C2 peut adopter les valeurs 0 et 1 uniquement quand C1 = 0 ou 8.

**5.** Un procédé d'incrémentation/décrémentation de coefficient de prise conforme à la revendication 2, dans lequel l'étape (b) exige en outre que quand ladite partie signe du coefficient de plusieurs bits Ci change, ledit indicateur de direction du coefficient de plusieurs bits Ci + 1 change, i = 2, ..., n-1 et quand ladite partie signe dudit indicateur de direction dudit coefficient de plusieurs bits le plus significatif C1 change, touslesdits indicateurs de direction desdits coefficients de plusieurs bits Ci changent, i = 2, ....n.

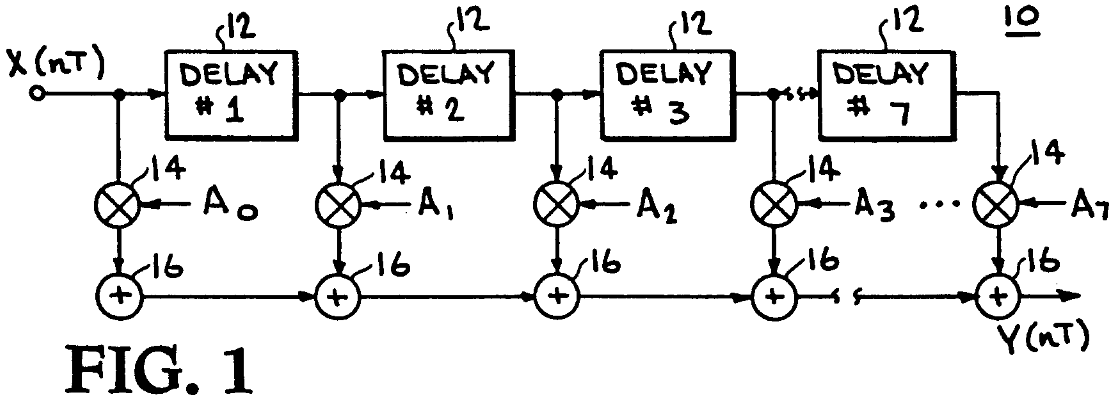


FIG. 1

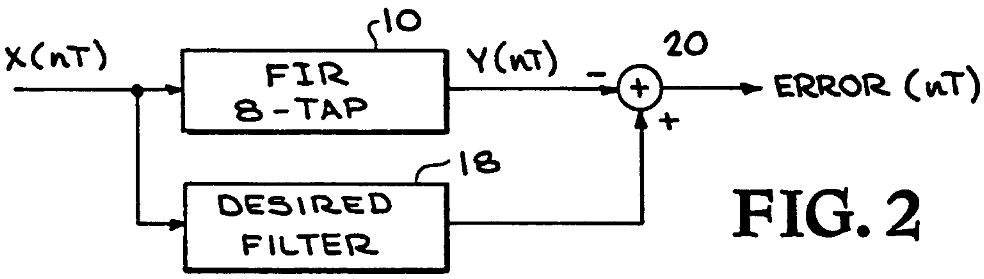


FIG. 2

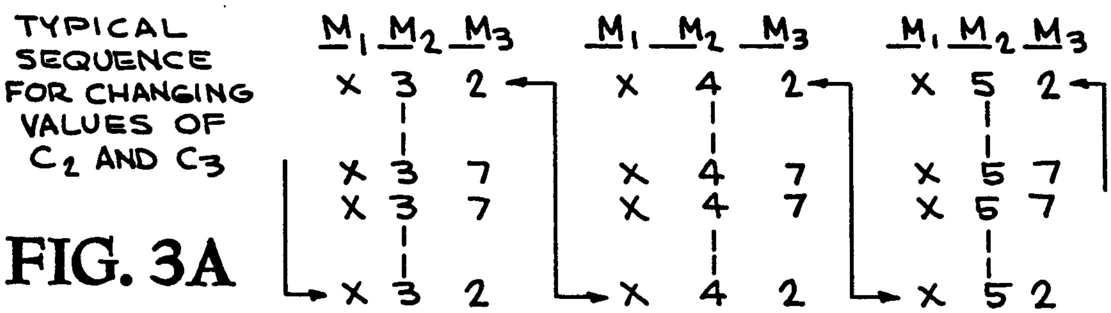


FIG. 3A

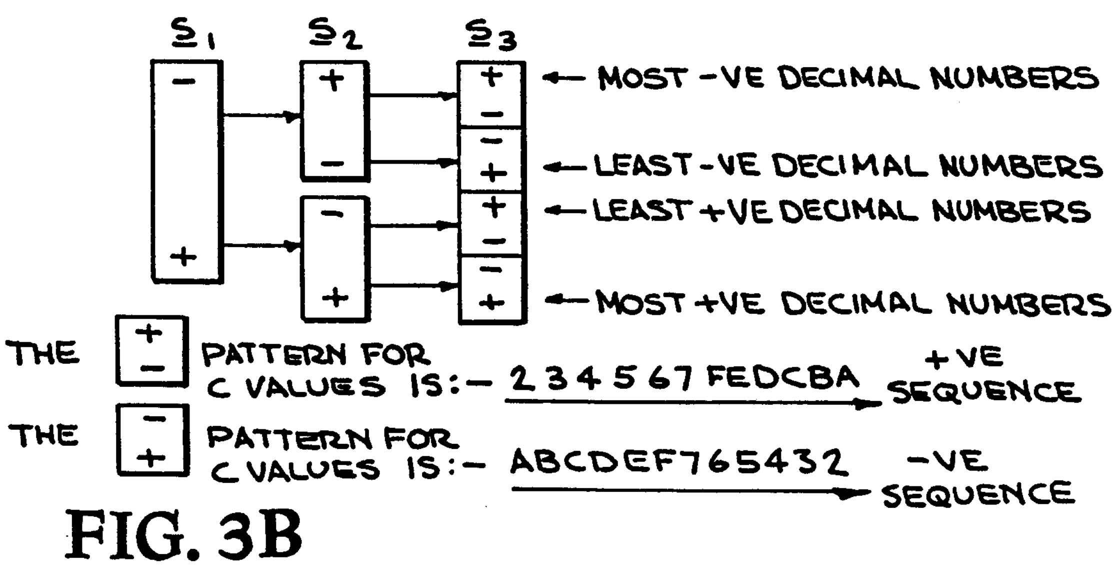


FIG. 3B

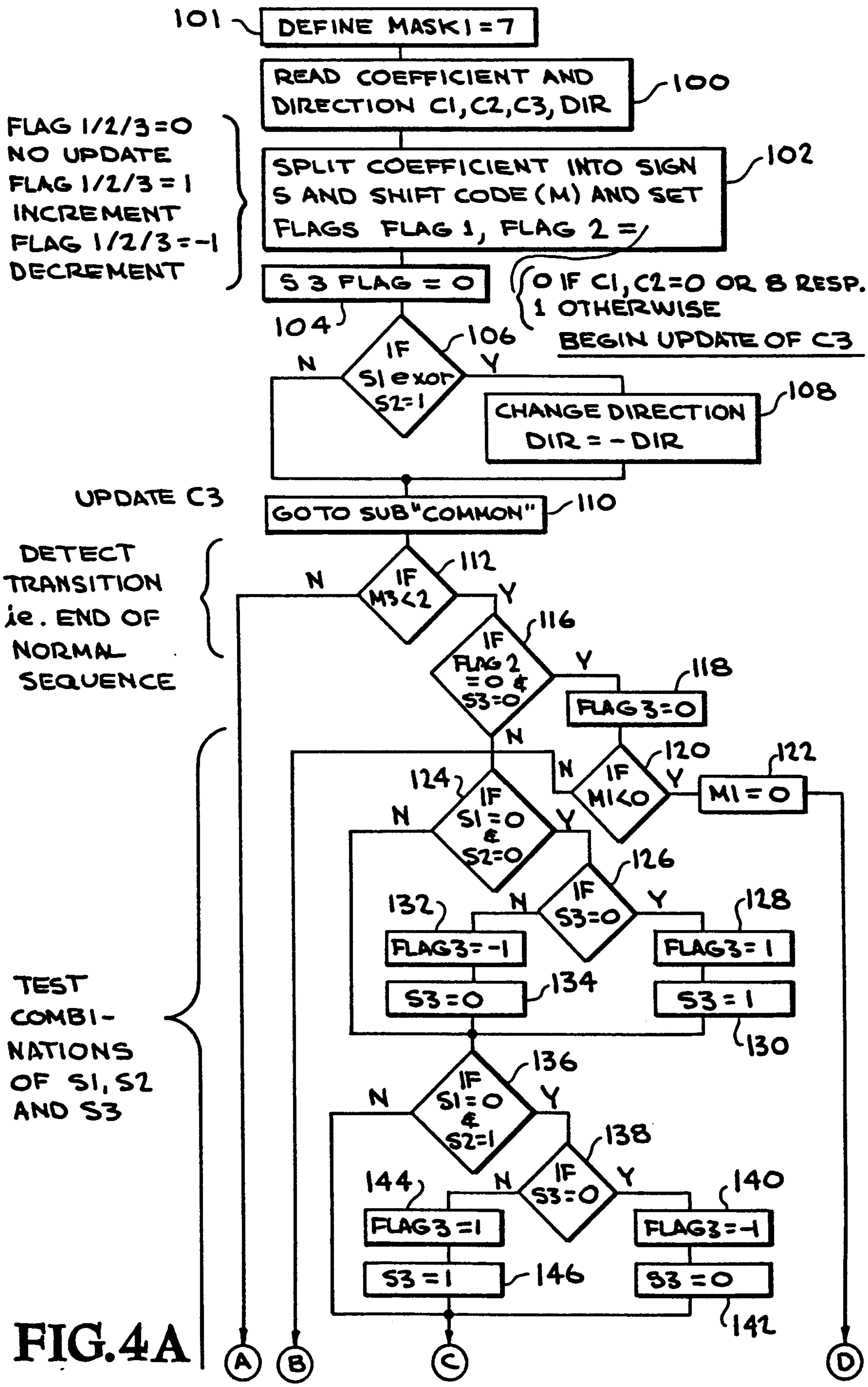
101
DEFINE MASK1=7
READ COEFFICIENT AND DIRECTION C1,C2,C3,DIR
100
FLAG 1/2/3=0 NO UPDATE
FLAG 1/2/3=1 INCREMENT
FLAG 1/2/3=-1 DECREMENT
SPLIT COEFFICIENT INTO SIGN S AND SHIFT CODE (M) AND SET FLAGS FLAG 1, FLAG 2 =
102
S 3 FLAG = 0
0 IF C1, C2=0 OR 8 RESP.
1 OTHERWISE
BEGIN UPDATE OF C3
104
IF S1 exor S2=1
106
N
Y
CHANGE DIRECTION DIR = -DIR
108
UPDATE C3
GOTO SUB "COMMON"
110
DETECT TRANSITION ie. END OF NORMAL SEQUENCE
IF M3<2
112
116
IF FLAG 2 =0 & S3=0
FLAG3=0
118
IF M1<0
120
M1=0
122
124
IF S1=0 & S2=0
IF S3=0
126
132
FLAG3=-1
FLAG3=1
128
S3=0
134
S3=1
130
TEST COMBI-NATIONS OF S1,S2 AND S3
IF S1=0 & S2=1
136
IF S3=0
138
144
FLAG3=1
FLAG3=-1
140
S3=1
146
S3=0
142
A
B
C
D
FIG.4A

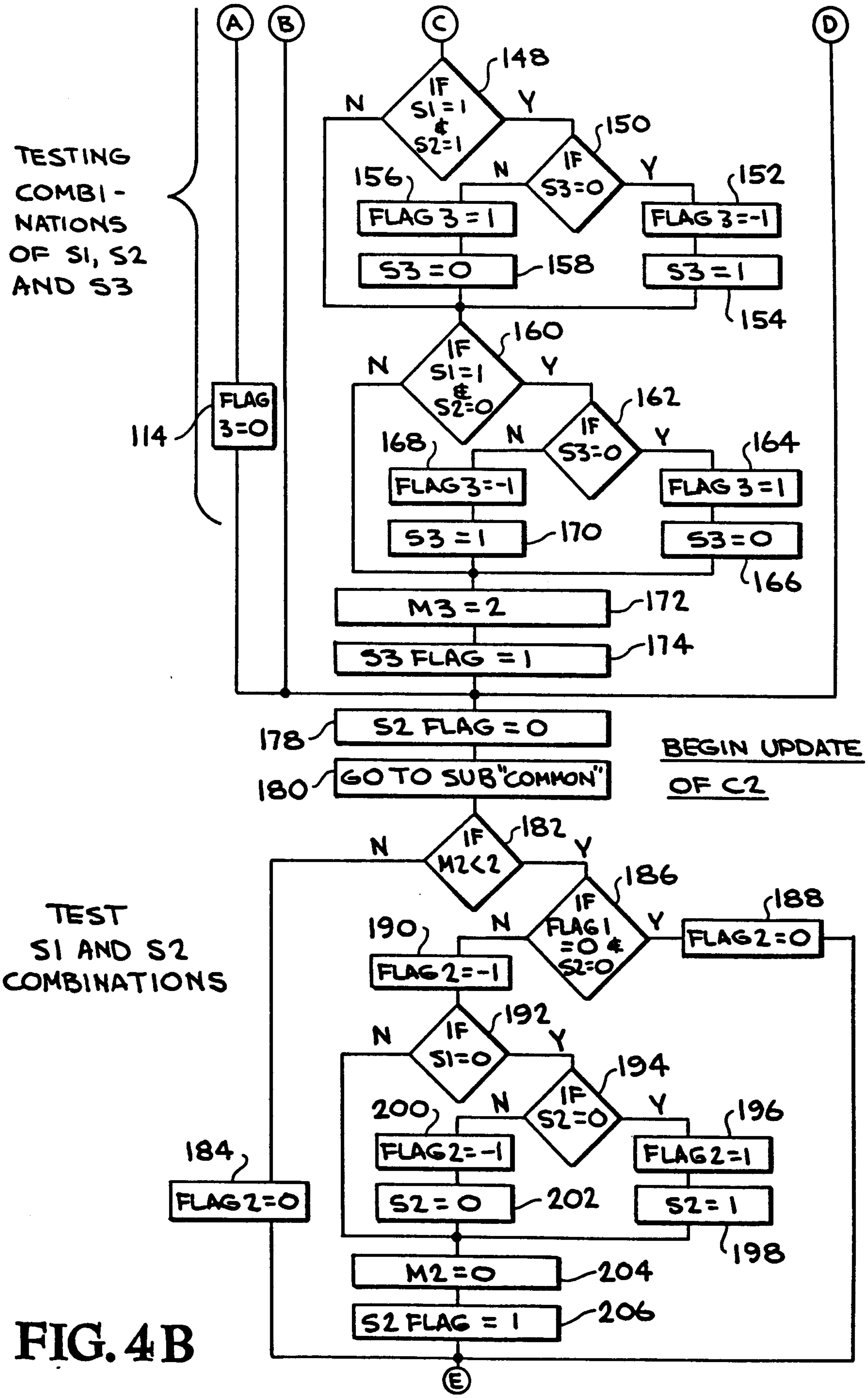
A
B
C
D
TESTING COMBI- NATIONS OF S1, S2 AND S3
IF S1=1 & S2=1
148
N
Y
IF S3=0
150
156
FLAG 3=1
FLAG 3=-1
152
S3=0
158
S3=1
154
IF S1=1 & S2=0
160
162
IF S3=0
168
FLAG3=-1
FLAG 3=1
164
S3=1
170
S3=0
166
114
FLAG 3=0
M3=2
172
S3 FLAG=1
174
178
S2 FLAG=0
180
GO TO SUB "COMMON"
BEGIN UPDATE OF C2
IF M2<2
182
186
IF FLAG1 =0 & S2=0
188
FLAG2=0
190
FLAG2=-1
TEST S1 AND S2 COMBINATIONS
IF S1=0
192
IF S2=0
194
200
FLAG2=-1
196
FLAG2=1
184
FLAG2=0
S2=0
202
S2=1
198
M2=0
204
S2 FLAG=1
206
E

FIG. 4B

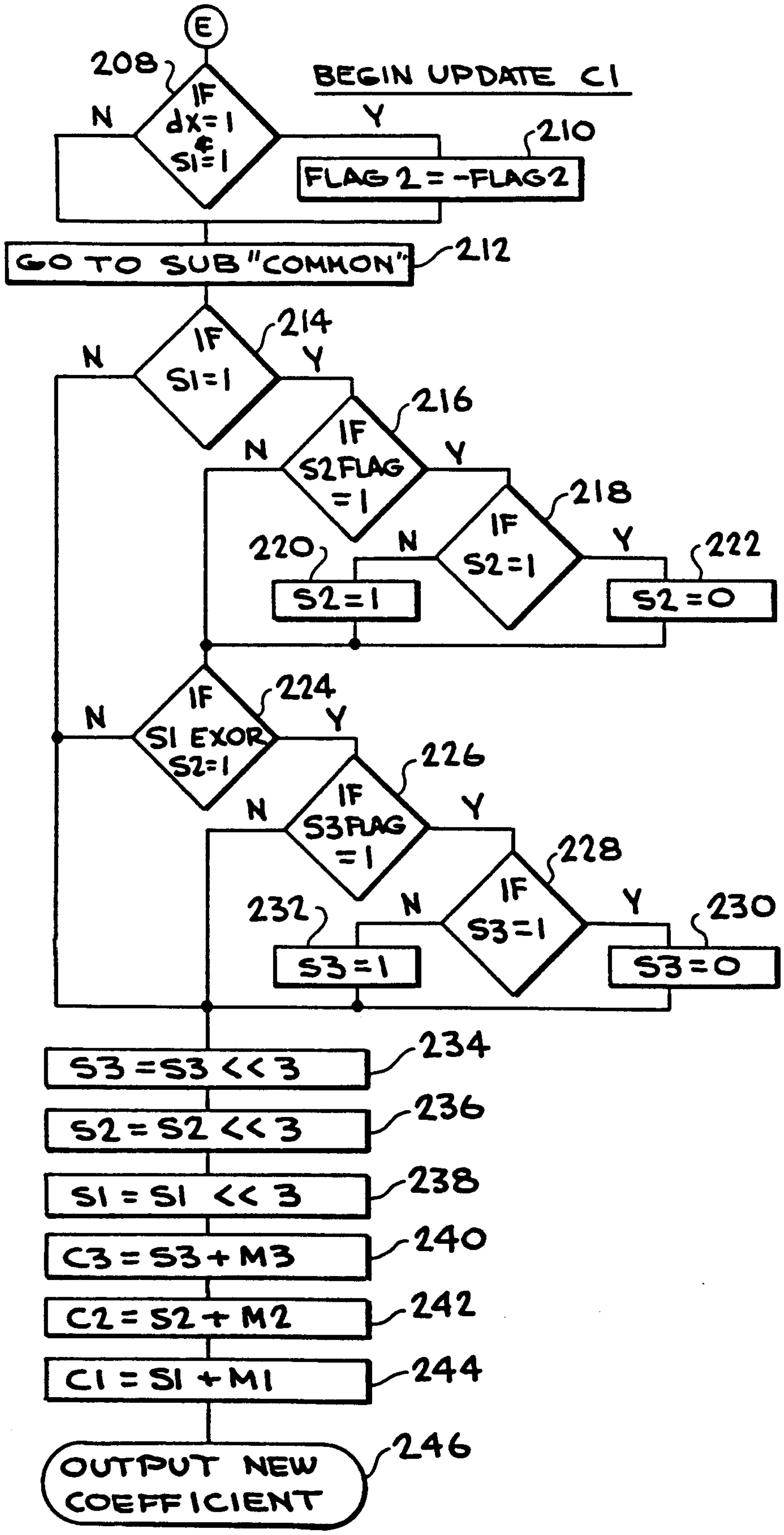
E
BEGIN UPDATE C1
208
IF dx=1 & S1=1
N
Y
210
FLAG 2 = -FLAG2
GO TO SUB "COMMON"
212
IF S1=1
214
N
Y
IF S2FLAG =1
216
N
Y
IF S2=1
218
N
Y
220
S2=1
222
S2=0
IF S1 EXOR S2=1
224
N
Y
IF S3FLAG =1
226
N
Y
IF S3=1
228
N
Y
232
S3=1
230
S3=0
S3 = S3 << 3
234
S2 = S2 << 3
236
S1 = S1 << 3
238
C3 = S3 + M3
240
C2 = S2 + M2
242
C1 = S1 + M1
244
OUTPUT NEW COEFFICIENT
246

FIG. 4C

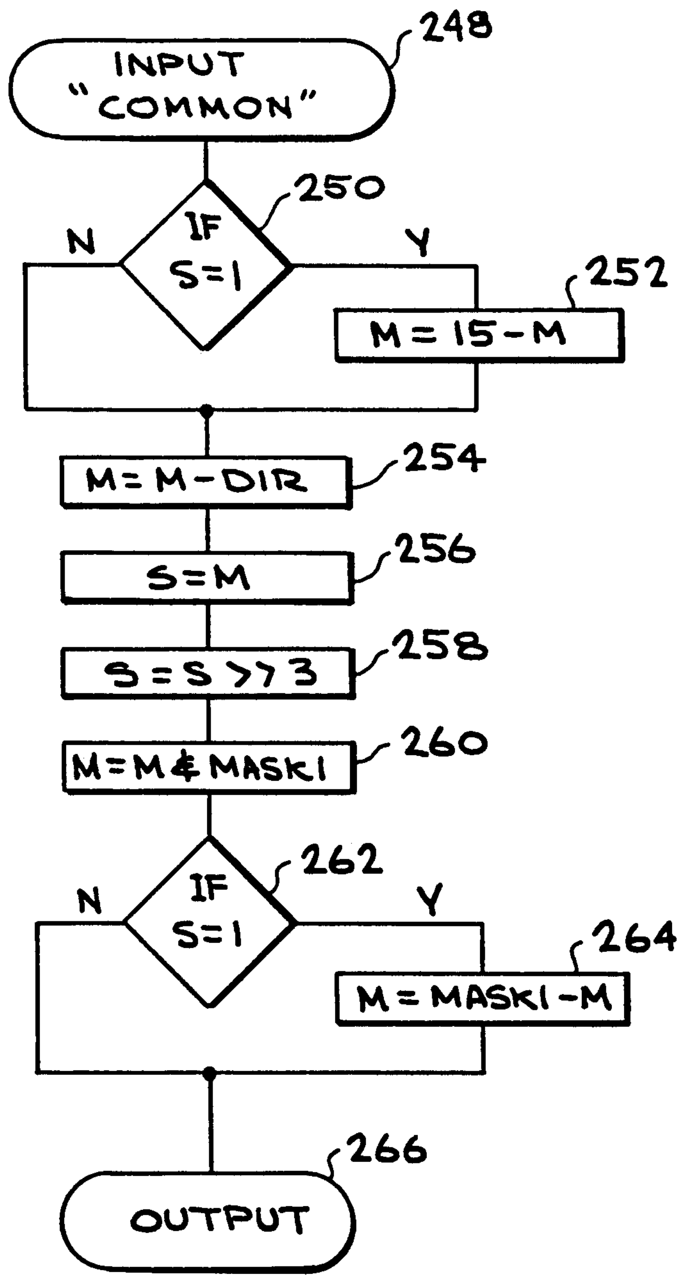
248
INPUT
"COMMON"
250
IF
S=1
N
Y
252
M = 15 - M
254
M = M - DIR
256
S = M
258
S = S >> 3
260
M = M & MASK1
262
IF
S=1
N
Y
264
M = MASK1 - M
266
OUTPUT

FIG. 4D